# EUROPEAN PATENT APPLICATION

(11) **EP 4 224 194 A1**
(43) Date of publication of application: **09.08.2023**
(21) Application number: 22155634.3
(22) Date of filing: 08.02.2022
(51) Int. Cl.: G01R 33/56, G01R 33/565, G06T 3/40, G06N 3/02

(54) **DISTORTION ARTIFACT REMOVAL AND UPSCALING IN MAGNETIC RESONANCE IMAGING**

(71) Applicant: Koninklijke Philips N.V., 5656 AG Eindhoven (NL)
(72) Inventor: GESSERT, Nils Thorben, Eindhoven (NL); WUELKER, Christian, Eindhoven (NL); NIELSEN, Tim, Eindhoven (NL)
(74) Representative: Philips Intellectual Property & Standards

(57) **Abstract**

Disclosed herein is a medical system (100, 300) comprising a memory (110) storing machine executable instructions (116) and a super resolution neural network (118). The super resolution neural network is configured to receive an initial magnetic resonance image (114, 114') descriptive of a subject (318), having a first resolution, and containing an image distortion artifact. The super resolution neural network is configured to output an enhanced magnetic resonance image in response to receiving the initial magnetic resonance image. The enhanced magnetic resonance image has a second resolution, that is higher than the first resolution, and has a reduction or removal of the image distortion artifact. Execution of the machine executable instructions causes a computational system (104) to: receive (200) the initial magnetic resonance image and receive (204) the enhanced magnetic resonance image in response to inputting the initial magnetic resonance image in to the super resolution neural network.

## Description

### TECHNICAL FIELD OF THE INVENTION

The invention relates to magnetic resonance imaging, in particular to artifact removal of magnetic resonance images and upscaling magnetic resonance images.

### BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field. Various quantities or properties of the subject can be measured spatially and imaged using MRI. A difficulty with performing magnetic resonance imaging is that it takes time to acquire the k-space data necessary to reconstruct the magnetic resonance imaging. The longer the acquisition time the more likely it is that the subject will move or that some other problem occurs. Another difficulty in performing magnetic resonance imaging is that there are a variety of things which can lead to spatial distortions of the magnetic resonance image.

United States patent application publication US 2020/0126190 A1 discloses selectively denoising medical images. In one method, one or more deep learning networks are trained to map corrupted images onto a first type and a second type of artifacts present in corresponding corrupted images. Then the one or more trained learning networks are used to single out the first and second types of artifacts from a particular medical image. The first type of artifacts is removed to a first extent and the second type of artifacts is removed to a second extent. The first and second extents may be different. For example, one type of artifacts can be fully suppressed while the other can be partially removed from the medical image

### SUMMARY OF THE INVENTION

The invention relates to a medical system, a method and a computer program product in the independent claims. Embodiments are given in the dependent claims.

Spatial distortions of the magnetic resonance image contain data or are descriptive of the subject. Embodiments of the invention use a super resolution neural network to simultaneously upscale the magnetic resonance while removing or reducing image distortion artifacts. These two operations are complementary. Image distortion artifacts encompass herein image artifacts that contain information descriptive of the subject or a true or undistorted magnetic resonance image. If image distortion artifacts are removed or mitigated before upscaling, then this information could be lost. Performing the removal of image distortion artifacts while upscaling may provide for better image distortion artifact removal and/or higher quality (more accurate) upscaling.

In one aspect the invention provides for a medical system that comprises a memory that stores machine-executable instructions and a super resolution neural network. A super resolution neural network as used herein encompasses a neural network used for image processing that receives an image with a first resolution and outputs a version of this image with an increased resolution, in other words a second resolution that is higher than the first resolution. Such neural networks are typically used for upscaling images such as used in increasing the resolution for watching videos or other uses.

The super resolution neural network is configured to receive an initial magnetic resonance image descriptive of a subject. That is to say there is an initial magnetic resonance image that detects at least a portion of the subject. The initial magnetic resonance image has a first resolution and contains an image distortion artifact. Used herein, an image distortion artifact is an artifact in the magnetic resonance image that contains information about a true or undistorted image of the subject. The term distortion implies that there is information contained in the image distortion artifact.

The super resolution neural network is configured to output an enhanced magnetic resonance image descriptive of the subject in response to receiving the initial magnetic resonance image. The enhanced magnetic resonance image has a second resolution and has a reduction or removal of the image distortion artifact. The second resolution is higher than the first resolution.

The super resolution neural network in this example is used in an unconventional way. In addition to upscaling or increasing the resolution of the initial magnetic resonance image, the super resolution neural network is also used to perform a reduction removal of the image distortion artifact. This may be beneficial because the image distortion artifact contains information about the undistorted or true image of the subject. By using this in the upscaling or super resolution neural network this information which is present in the image distortion artifact is therefore available for performing the upscaling or the increase of the resolution of the initial magnetic resonance image.

The medical system further comprises a computational system. Execution of the machine-executable instructions causes the computational system to first receive the initial magnetic resonance image and then receive the enhanced magnetic resonance image in response to inputting the initial magnetic resonance image into the super resolution neural network.

As was mentioned before, this may be beneficial because the image distortion artifact may, for example, contain information descriptive of the subject. If one were to apply an image filter or other technique to remove the image distortion artifact before performing the upscaling, then it may result in an enhanced magnetic resonance image that has lower image quality.

Neural network architectures that may be used for implementing the super resolution neural network include: VDSR (Very deep Super-Resolution Network), SRResNet (Super-resolution Residual Network), SRDenseNet (Super-Resolution Densely Connected Network), EDSR (Enhanced Deep Super-Resolution Network), MDSR (Multi-Scale Deep Super-Resolution System), or other types of feed-forward neural networks that are not (entirely) convolutional.

The training of the super resolution neural network may be straightforward. Magnetic resonance images at the second resolution may be obtained from clinical studies or dedicated acquisitions. The image can then be downscaled to the first resolution and image distortion artifacts can be artificially added either in image space or in k-space. The downscaling operation itself can be chosen such that it already introduces the distortion artifact by itself. For example, cropping in k-space will downscale the image and introduce Gibb's ringing artifacts. The downscaled image with added artifacts and the original image at the second resolution can be used for training the neural network.

In another embodiment the image distortion artifact is any one of the following: a truncation artifact, a motion artifact, a patient motion artifact, a pulsation artifact, a cardiac artifact such as a movement artifact, an aliasing artifact, a wrapped-around artifact, and a Gibbs ringing image artifact. These artifacts may be beneficial because they contain information which is descriptive of the subject. Training a super resolution neural network to remove or reduce these artifacts at the same time as upscaling or increasing the resolution may provide for an enhanced magnetic resonance image that has higher quality or is better interpolated.

In another embodiment the image distortion artifact is a blooming artifact. A blooming artifact is an image artifact in a magnetic resonance image that is a susceptibility artifact that may occur in the presence of paramagnetic substances. Training the super resolution neural network to remove the blooming artifact may also be beneficial because the blooming artifact is seen around specific compounds such as hemosiderin or calcification. It may also be visible in the presence of metal or gas such as due to an air embolism. The blooming refers to the fact that the lesion or object, such as the medical or traumatic fragments, may cause the blooming artifact or lesion to appear larger than it is. Having the super resolution neural network correct this may be beneficial because it may make the lesion or object the proper size during the upscaling.

In another embodiment the image distortion artifact comprises information descriptive of the subject. This may be beneficial because the information contained in the image distortion artifact may be useful in performing the upscaling of the initial magnetic resonance image into the enhanced magnetic resonance image.

In another embodiment the memory further stores an image filter module configured for removing random image errors from images with the first resolution. A random image error as used herein is an image error that occurs due to random or spurious measurements either in k-space or in image space. For example, data or errors or random noise in k-space can lead to regular or pattern-like images in a magnetic resonance image in image space. Although this may lead to a regular pattern in image space it is still random in k-space. An example of image errors would for example be noise either in k-space or in image space. In this case the random image errors are not correlated to image content and do not contain information descriptive of the subject.

Execution of the machine-executable instructions further causes the computational system to remove random image errors from the initial magnetic resonance image by inputting the initial magnetic resonance image into the image filter module, before inputting the initial magnetic resonance image into the super resolution neural network.

In this embodiment the image filter module is applied to the initial magnetic resonance image before it is upscaled using the super resolution neural network. This is a particularly beneficial way of doing this because the image filter module removes these random image errors, or in some cases noise, before the upscaling. This works because the random image errors are not correlated or connected to a true or undistorted image of the subject. These image artifacts or noise may therefore be removed. This approach is beneficial as it avoids undesired enhancement of the random image errors by the super resolution neural network. Therefore, this embodiment may be beneficial because it may provide for an increased quality of the enhanced magnetic resonance image.

In another embodiment the image filter module is an algorithmic image filter module. That is to say the image filter module is not constructed using a neural network. There is an algorithm which is applied and used in the image filter module. Preferably the denoising image filter module is configured for denoising images with the first resolution. The algorithmic image filter module could for example be an algorithmic denoising filter.

Examples of algorithm image filter modules include: linear smoothing filters, such as convolution with a Gaussian filter kernel; anisotropic diffusion; non-local means (NLM), other non-linear filters, such as median filtering; wavelet thresholding; block-matching and 3D filtering (BM3D).

In another embodiment the denoising filter module is an image filtering neural network configured for removing the random image errors from images with the first resolution. The image filtering neural network is a denoising neural network. For example, the image filtering neural network may be trained to remove noise from images. This denoising filter module may be trained in a variety of ways. In one example, magnetic resonance images with the first resolution, which do not have any noise or random image errors in them, may be artificially added to them. The image with the artificial or random image artifacts added to it may be used as the input to the neural network and the original image without the errors may then be used for deep learning. This could be done with a combination of many different images.

Various types of random image errors can be trained for. For example, the image can be transformed into k-space and then random image artifacts or noise can be added in k-space and the image then reconverted or reconstructed in image space. A variety of types of neural networks may be used for implementing the image filtering neural network. Most types of neural networks which are suitable for image processing may be used.

Examples of image filtering neural networks include: feed-forward convolutional neural networks, potentially bias-free and potentially with skip connections, e.g., DnCNN, U-Net, ResNet, DenseNet, Encoder-decoder network (for denoising, the encoder-decoder net is than simply referred to as an auto-encoder).

In another embodiment the super resolution neural network is structured for using a predetermined super resolution neural network architecture with an increased capacity to enable removal of the magnetic resonance image artifact and/or to enable partial reconstruction of the enhanced magnetic resonance image using the image artifact. For example, there exist a relatively large number of neural network architectures which may be suitable for making a super resolution neural network. The capacity in several different ways may be increased so that it is straight forward to train the super resolution neural network to also perform a reduction or removal of the image distortion artifact.

In another embodiment the increased capacity for the super resolution neural network is added by providing the predetermined super resolution neural network architecture with an increased number of kernels per convolutional layer. This may also, in addition or alternatively, be performed by providing the predetermined neural network architecture with an increased number of convolutional layers. So essentially, one can take a neural network architecture which is suitable for super resolution or upscaling and increase the number of kernels per convolutional layer and/or increase the number of convolutional layers.

In another embodiment the predetermined neural network comprises neural network building blocks. The increased capacity is added by providing the predetermined super resolution neural network with an additional repetition of one or more of the neural network building blocks. For example, the neural network may have a number of structures within it. One way of increasing the capacity is to increase the number of these macroscopic structures within the neural network architecture.

In another embodiment the medical system further comprises a magnetic resonance imaging system. The memory further contains pulse sequence commands configured to control the magnetic resonance imaging system to acquire k-space data. Execution of the machine-executable instructions further causes the computational system to acquire the k-space data by controlling the magnetic resonance imaging system with the pulse sequence commands. Execution of the machine-executable instructions further causes the computational system to reconstruct the initial magnetic resonance image from the k-space data.

In another embodiment reconstruction of the initial magnetic resonance image causes the image distortion artifact. For example, the image distortion artifact may be an image reconstruction artifact such as folding or Gibbs ringing. This embodiment may be beneficial because the super resolution neural network may be able to correct for artifacts, which are generated by the reconstruction of the k-space data, to the initial magnetic resonance image which is in image space.

In another aspect the invention provides for a method of medical imaging. The method comprises receiving an initial magnetic resonance image. The method further comprises receiving an enhanced magnetic resonance image in response to inputting the initial magnetic resonance image into a super resolution neural network. The super resolution neural network is configured to receive the initial magnetic resonance image, which is descriptive of the subject. The initial magnetic resonance image has a first resolution and contains an image distortion artifact. The super resolution neural network is configured to output an enhanced magnetic resonance image descriptive of the subject in response to receiving the initial magnetic resonance image. The enhanced magnetic resonance image has a second resolution and has a reduction or removal of the image distortion artifact. The second resolution is higher than the first resolution.

In another aspect the invention provides for a computer program product comprising machine-executable instructions for execution by a computational system. The computational system may for example be used for controlling a medical system such as is described herein. Execution of the machine-executable instructions causes the computational system to receive an initial magnetic resonance image descriptive of a subject. Execution of the machine-executable instructions further causes the computational system to receive an enhanced magnetic resonance image in response to inputting the initial magnetic resonance image into a super resolution neural network. The super resolution neural network is configured to receive the initial magnetic resonance image. The initial magnetic resonance image has a first resolution and contains an image distortion artifact. The super resolution neural network is configured to output an enhanced magnetic resonance image descriptive of the subject in response to receiving the initial magnetic resonance image. The enhanced magnetic resonance image has a second resolution and has a reduction removal of the image distortion artifact. The second resolution is higher than the first resolution. The computer program product may also comprise the super resolution neural network.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid-state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan.

A Magnetic Resonance Imaging (MRI) image or Magnetic Resonance (MR) image is defined herein as being the reconstructed two- or three-dimensional visualization of anatomic data contained within the k-space data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of a medical system;
Fig. 2 shows a flow chart which illustrates a method of using the medical system of Fig. 1;
Fig. 3 illustrates an example of a medical system;
Fig. 4 shows a flow chart which illustrates a method of using the medical system of Fig. 3; and
Fig. 5 illustrates the use of a image filter module and a super resolution neural network cooperatively.

### DETAILED DESCRIPTION OF EMBODIMENTS

Like numbered elements in these figures are either equivalent elements or perform the same function. Elements which have been discussed previously will not necessarily be discussed in later figures if the function is equivalent.

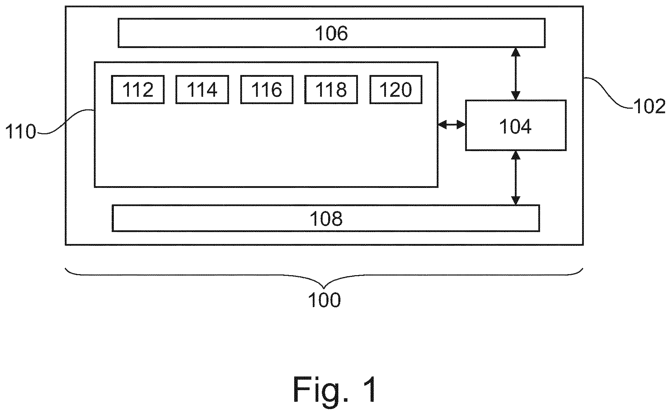

Fig. 1 illustrates an example of a medical system 100. The medical system 100 is shown as comprising a computer 102 that has a computational system 104. The computer 102 is for example intended to represent one or more computers or computer systems that may be located in one or more locations. The computational system 104 is also intended to represent one or more computational systems 104 that could be in possibly one or multiple locations. The computational system 104 is shown as being in communication with an optional hardware interface and an optional user interface 108. If other components of the medical system 100 are present, then the computational system 104 could use the hardware interface 106 to communicate and control them. The user interface 108 may provide a means for an operator to operate and control the medical system 100.

The computational system 104 is further shown as being in communication with a memory 110. The memory 110 is intended to represent any type of memory or storage which the computational system 104 may be in communication with. In some examples the memory 110 may be a non-transitory storage medium.

The memory 110 is shown as containing machine-executable instructions 112. The machine-executable instructions 112 enable the computational system 104 to perform basic computational and data analysis tasks. The machine-executable instructions 112 may also enable the computational system 104 to communicate with and/or control other components and apparatus.

The memory 110 is further shown as containing an initial magnetic resonance image 114 that has a first resolution. The memory 110 is further shown as containing an optional image filter module 116 that may be configured to remove random image errors from the initial magnetic resonance image 114. The memory 110 is further shown as containing a super resolution neural network 118 that is configured to receive the initial magnetic resonance image 114 and output an enhanced magnetic resonance image 120. The enhanced magnetic resonance image 120 has a second resolution which is greater than the first resolution. The enhanced magnetic resonance image 120 has also had an image distortion artifact removed or reduced in it that was present in the initial magnetic resonance image 114.

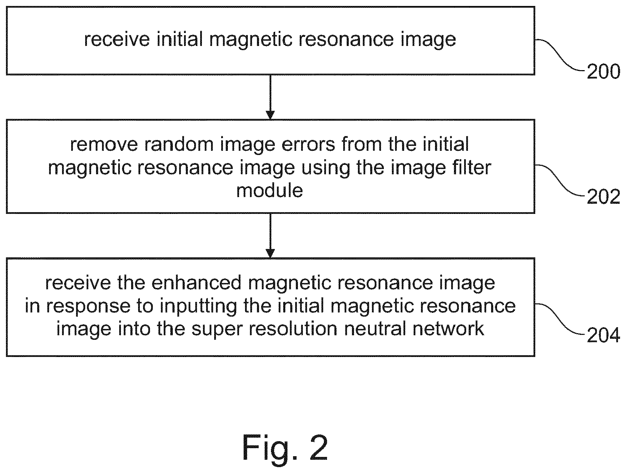

Fig. 2 shows a flowchart which illustrates a method of operating the medical system 100 of Fig. 1. First, in step 200, the initial magnetic resonance image 114 is received. Next, step 202 is optionally performed. In step 202 the initial magnetic resonance image 114 is input into the image filter module 116. This has the effect of removing or reducing the random image errors which may be present in the initial magnetic resonance image 114. Next, in step 204, the initial magnetic resonance image is input into the super resolution neural network 118. In response, the super resolution neural network 118 outputs the enhanced magnetic resonance image 120.

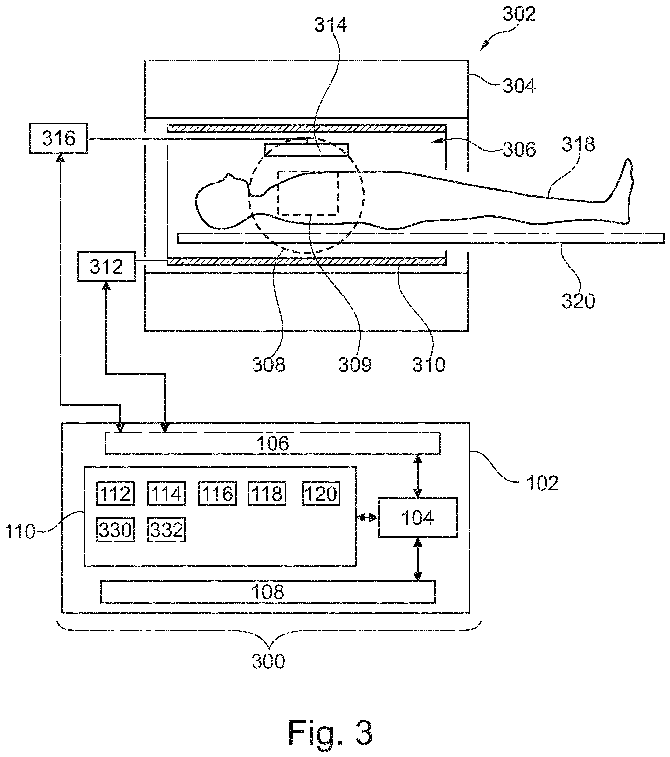

Fig. 3 illustrates a further example of the medical system 300. The medical system 300 is similar to the medical system depicted in Fig. 1 except that it additionally comprises a magnetic resonance imaging system 302 that is controlled by the computational system 104. The example illustrated in Fig. 3 is a magnetic resonance imaging system 302.

The magnetic resonance imaging system 302 comprises a magnet 304. The magnet 304 is a superconducting cylindrical type magnet with a bore 306 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The k-space data that is acquired typically acquried for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309.

Within the bore 306 of the magnet there is also a set of magnetic field gradient coils 310 which is used for acquisition of preliminary k-space data to spatially encode magnetic spins within the imaging zone 308 of the magnet 304. The magnetic field gradient coils 310 connected to a magnetic field gradient coil power supply 312. The magnetic field gradient coils 310 are intended to be representative. Typically magnetic field gradient coils 310 contain three separate sets of coils for spatially encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio-frequency coil 314 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The radio-frequency coil 314 is connected to a radio frequency transceiver 316. The radio-frequency coil 314 and radio frequency transceiver 316 may be replaced by separate transmit and receive coils and a separate transmitter and receiver. It is understood that the radio-frequency coil 314 and the radio frequency transceiver 316 are representative. The radio-frequency coil 314 is intended to also represent a dedicated transmit antenna and a dedicated receive antenna. Likewise the transceiver 316 may also represent a separate transmitter and receivers. The radio-frequency coil 314 may also have multiple receive/transmit elements and the radio frequency transceiver 316 may have multiple receive/transmit channels.

The transceiver 316 and the gradient controller 312 are shown as being connected to the hardware interface 106 of the computer system 102. Both of these components, as well as others such as the subject support supplying positional data, may supply the sensor data 126.

The memory is shown as containing pulse sequence commands 330. The pulse sequence commands 330 are instructions or data which may be converted into instructions which the computational system 104 can use to control the magnetic resonance imaging system 302 to acquire k-space data 332 from the field of view 309. The memory 110 is further shown as containing the k-space data 332. The k-space data 332 may be reconstructed into the initial magnetic resonance image 114.

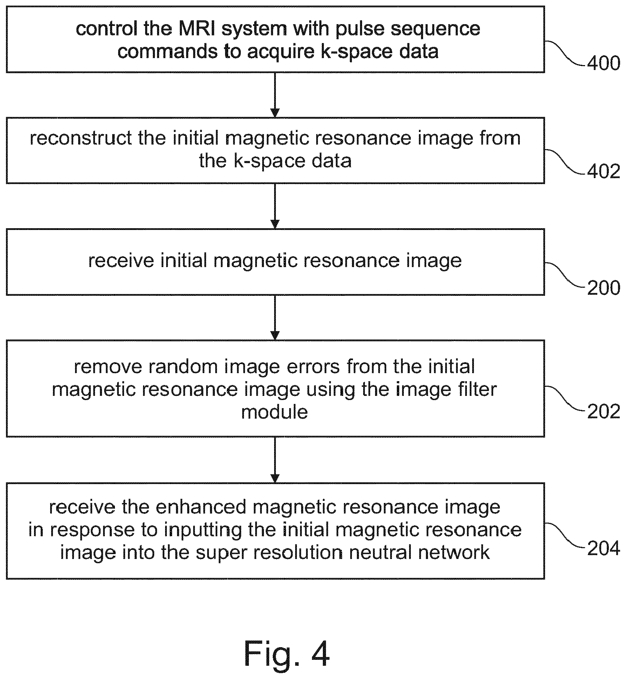

Fig. 4 shows a flowchart which illustrates a method of operating the medical system 300 of Fig. 3. First, in step 400, the pulse sequence commands 330 are used to control the magnetic resonance imaging system 302 to acquire the k-space data 332. Next, in step 402, the initial magnetic resonance image 114 is reconstructed from the k-space data 332. The method then proceeds to steps 200, optionally step 202, and step 204 as was illustrated and discussed in Fig. 2.

Image quality (IQ) is a crucial aspect of MRI as it has a substantial impact on diagnostic confidence and reading time of a radiologist. Higher image quality, characterized, e.g., by a high signal-to-noise ratio (SNR) and perceived image sharpness, could potentially be achieved by long acquisition procedures. For MRI, long acquisition times are very costly and thus often not an option. Typically, fast acquisition techniques, e.g., using specialized sampling techniques, are used which typically lead to lower image quality. Noise, Gibb's ringing, and loss of resolution are common problems that are traditionally addressed using filtering and zero padding in k-space, followed by filtering in the spatial domain. However, zero padding substantially limits the effectivity of subsequent filtering operations, and, in general, the achieved IQ improvement is limited. Furthermore, classical anti-ringing filters in k-space damp down measured high-frequency information at the cost of sharpness and resolution.

As disclosed herein, a denoising neural network (image filter module) is optionally used before an initial magnetic resonance image is input into a super resolution neural network that is configured for removing or reducing image distortion artifacts.

Image quality improvement (IQ-Boost) for MRI is a crucial aspect for imaging systems as high-quality images are required to derive a reliable diagnosis. However, the long acquisition times and thus high costs of MRI acquisition have led to the wide-spread deployment of fast acquisition methods that come at the cost of IQ. Usually, images are affected by noise and Gibb's ringing artifacts, they have a low resolution and low perceived sharpness, resulting in reduced IQ. One way to improve IQ is to apply post-processing methods that remove artifacts and increase the resolution of the acquired images, by better preserving the information that was measured.

A traditional way to improve IQ after acquisition is to employ a series of processing steps that increase the number of voxels and remove artifacts. The image's number of voxels in the spatial domain can be increased by apply zero padding k-space, before the image is transformed into the spatial domain. Zero-padding in k-space leads to interpolation in the spatial domain and a larger number of voxels which can lead to slightly improved IQ. However, the interpolation step changes the image's characteristics, in particular, Gibb's ringing artifacts. After interpolation, these artifacts are difficult to remove.

Also, for isolated problems such as MRI noise removal and MRI super-resolution, dedicated neural networks have been presented. However, the chain of processing steps and potential interactions are not considered and usually, these methods require costly, high-quality MRI scans for training. A method is described below:
Step 1) Train an NN (one possible implementation of a image filter module) to detect and predict noise (random image errors) in an MR image. The NN can either be trained on complex or magnitude images. Furthermore, the training images do not necessarily have to be MR images and other types images can be used as well, as image noise is not specific to MRI. In the training procedure, the NN receives images artificially corrupted by noise and predicts the noise that was added to the image. Training data is obtained by adding noise to images. The original images serve as a ground-truth and the noisy images are used as input for training. Different types of noise can be used for this procedure. In particular, noise artifacts caused by undersampling techniques are taken into account by including undersampled MR scans during training.
Step 2) Train an NN for super-resolution and for removing image distortion artifacts, such as Gibbs ringing. Once more, the NN can be trained on different types of images, although it is applied to MR in the end. During training, the NN receives low-resolution images that are up sampled to a higher resolution. Training data can be generated by using, e.g., high-resolution natural images that are down sampled by a certain factor. The high-resolution images serve as a ground-truth and the down sampled images are shown to the network as input during training.

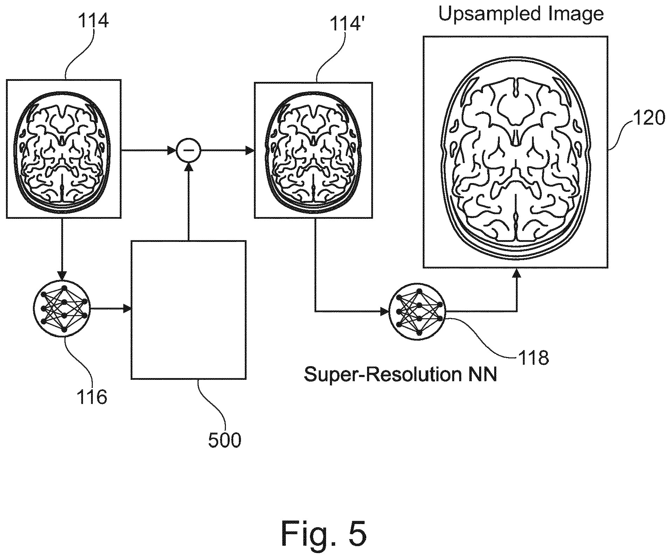

Fig. 5 illustrates an example of generating an up sampled magnetic resonance image 120. Initially the initial magnetic resonance image 114 is received. This is then input into the optional image filter module 116, which outputs identified noise or random image error 500. This random image error 500 may be subtracted from the initial magnetic resonance image 114 to generate an initial magnetic resonance image 114' with random image errors removed or reduced. This initial magnetic resonance image 114' is then input into the super resolution neural network 118, which then outputs the enhanced magnetic resonance image 120. Fig. 5. Is an illustration of the IQ-boost method application. First, an NN predicts noise in the image that is then removed. Second, an NN predicts residual ringing artifacts, that are also removed and up samples to a higher resolution. The super resolution network upsamples the image without random errors to the second resolution while also removing image distortion artifacts such as Gibb's ringing.

The presented IQ-boost method is very versatile and can be applied on top of any MR acquisition pipeline. The method solely operates on reconstructed images. Therefore, with appropriate adjustments, the method can be applied to images where reconstruction was performed from fully sampled or accelerated scans such as SENSE, Compressed SENSE, or HyperSense scans. This means that both older and newer systems could be equipped with the method to improve IQ.

In particular, low-cost MR systems that are affected by image artifacts more severely, will greatly benefit from this method. Furthermore, it should be noted that the computation time of the IQ-boost package will not be prohibitive and only lead to a minor runtime increase as the IQ-boost NNs can be small.

For the design and application of the described invention, examples may contain one or more of the following features:
- In one example, one of the neural networks could be omitted or replaced by an alternative technique. For example, denoising could be performed with a traditional filtering system.
- Another example is the combination of some of the neural networks. Training of separate network for different artifacts could be combined into a single network.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: computer
- 104: computational system
- 106: hardware interface
- 108: user interface
- 110: memory
- 112: machine executable instructions
- 114: initial magnetic resonance image
- 114': initial magnetic resonance image with random image errors removed or reduced
- 116: image filter module
- 118: super resolution neural network
- 120: enhanced magnetic resonance image
- 200: receive the initial magnetic resonance image
- 202: remove random image errors from the initial magnetic resonance image by inputting the initial magnetic resonance image into the image filter module before inputting the initial magnetic resonance image into the super resolution neural network
- 204: receive the enhanced magnetic resonance image in response to inputting the initial magnetic resonance image in to the super resolution neural network
- 300: medical system
- 302: magnetic resonance imaging system
- 304: magnet
- 306: bore of magnet
- 308: imaging zone
- 309: field of view
- 310: magnetic field gradient coils
- 312: magnetic field gradient coil power supply
- 314: radio-frequency coil
- 316: transceiver
- 318: subject
- 320: subject support
- 330: pulse sequence commands
- 332: k-space data
- 400: acquire the k-space data by controlling the magnetic resonance imaging system with the pulse sequence commands
- 402: reconstruct the initial magnetic resonance image from the k-space data
- 500: noise or random image error

## Claims

1. A medical system (100, 300) comprising:
- a memory (110) storing machine executable instructions (116) and a super resolution neural network (118), wherein the super resolution neural network is configured to receive an initial magnetic resonance image (114, 114') descriptive of a subject (318), wherein the initial magnetic resonance image has a first resolution and contains an image distortion artifact, wherein the super resolution neural network is configured to output an enhanced magnetic resonance image descriptive of the subject in response to receiving the initial magnetic resonance image, wherein the enhanced magnetic resonance image has a second resolution and has a reduction or removal of the image distortion artifact, wherein the second resolution is higher than the first resolution;
- a computational system (104), wherein execution of the machine executable instructions causes the computational system to:
- receive (200) the initial magnetic resonance image; and
- receive (204) the enhanced magnetic resonance image in response to inputting the initial magnetic resonance image in to the super resolution neural network.

2. The medical system of claim 1, wherein the image distortion artifact is any one of the following, a ringing artifact, a truncation artifact, a motion artifact, a patient motion artifact, a pulsation artifact, a cardiac artifact, a blooming artifact, an aliasing artifact, a wrap-around artifact, and a Gibbs ringing image artifact.

3. The medical system of claim 1 or 2, wherein the super resolution neural network is configured to partially reconstruct the enhanced magnetic resonance image using the image distortion artifact.

4. The medical system of claim 1, 2, or 3, wherein image distortion artifact comprises information descriptive of the subject.

5. The medical system of any one of the preceding claims, wherein the memory further stores an image filter module (116) configured for removing random image errors (500) from images with the first resolution, wherein execution of the machine executable instructions further causes the computational system to remove (202) random image errors from the initial magnetic resonance image by inputting the initial magnetic resonance image into the image filter module before inputting the initial magnetic resonance image into the super resolution neural network.

6. The medical system of claim 5, wherein the image filter module is an algorithmic image filter module, preferably the denoising image filter module is configured for denoising images with the first resolution.

7. The medical system of claim 5, wherein the denoising filter module is an image filtering neural network configured for removing the random image errors from images with the first resolution, preferably the image filtering neural network is a denoising neural network.

8. The medical system of any one of the preceding claims, wherein the super resolution neural network is structured using a predetermined super resolution neural network architecture with an increased capacity to enable removal of the image distortion artifact and/or to enable partial reconstruction of the enhanced magnetic resonance image using the image artifact.

9. The medical system of claim 8, wherein the increased capacity is added by providing the predetermined super resolution neural network architecture with an increased number of kernels per convolutional layer and/or by providing the predetermined neural network architecture with an increased number of convolutional layers.

10. The medical system of claim 8 or 9, wherein the predetermined neural network comprises neural network building blocks, wherein the increased capacity is added by providing the predetermined super resolution neural network with additional repetitions of one or more of the neural network building blocks.

11. The medical system of any one of the preceding claims, wherein the medical system further comprises a magnetic resonance imaging system, wherein the memory further contains pulse sequence commands configured to control the magnetic resonance imaging system to acquire k-space data (332), wherein execution of the machine executable instructions further causes the computational system to:
- acquire (400) the k-space data by controlling the magnetic resonance imaging system with the pulse sequence commands; and
- reconstruct (402) the initial magnetic resonance image from the k-space data.

12. The medical system of claim 11, wherein reconstruction of the initial magnetic resonance image causes the image distortion artifact.

13. A method of medical imaging, the method comprising:
- receiving (200) an initial magnetic resonance image (114, 114'); and
- receiving (204) an enhanced magnetic resonance image (120) in response to inputting the initial magnetic resonance image in to a super resolution neural network (118), wherein the super resolution neural network is configured to receive the initial magnetic resonance image that is descriptive of a subject (318), wherein the initial magnetic resonance image has a first resolution and contains an image distortion artifact, wherein the super resolution neural network is configured to output an enhanced magnetic resonance image descriptive of the subject in response to receiving the initial magnetic resonance image, wherein the enhanced magnetic resonance image has a second resolution and has a reduction or removal of the image distortion artifact, wherein the second resolution is higher than the first resolution.

14. A computer program product comprising machine executable instructions (112) for execution by a computational system, wherein execution of the machine executable instructions causes the computational system to:
- receive (200) an initial magnetic resonance image (114, 114') descriptive of a subject (318); and
- receive (204) an enhanced magnetic resonance image (120) in response to inputting the initial magnetic resonance image in to a super resolution neural network (118), wherein the super resolution neural network is configured to receive the initial magnetic resonance image, wherein the initial magnetic resonance image has a first resolution and contains an image distortion artifact, wherein the super resolution neural network is configured to output the enhanced magnetic resonance image descriptive of the subject in response to receiving the initial magnetic resonance image, wherein the enhanced magnetic resonance image has a second resolution and has a reduction or removal of the image distortion artifact, wherein the second resolution is higher than the first resolution.
